# EUROPÄISCHE PATENTSCHRIFT

(11) **EP 1 271 749 B1**
(45) Veröffentlichungstag und Bekanntmachung des Hinweises auf die Patenterteilung: **16.11.2005**
(21) Anmeldenummer: 02006245.1
(22) Anmeldetag: 20.03.2002
(51) Int. Cl.: H02K 11/04, H02K 5/22

(54) **Elektromotor**
Electric motor
Moteur électrique

(30) Priorität: 27.06.2001 DE 10130950
(43) Veröffentlichungstag der Anmeldung: 02.01.2003
(73) Patentinhaber: Behr GmbH & Co. KG, 70469 Stuttgart (DE)
(72) Erfinder: Pubrl, Harald, Dipl.-Ing., 70437 Stuttgart (DE)
(74) Vertreter: Grauel, Andreas

(56) Entgegenhaltungen:
- EP-A- 0 558 181
- EP-A- 1 235 329
- WO-A-00/44208
- DE-A- 19 723 664
- GB-A- 2 174 253
- US-A- 4 810 917
- US-A- 5 943 214
- US-A- 5 973 430
- PATENT ABSTRACTS OF JAPAN vol. 004, no. 162 (E-033), 12. November 1980 (1980-11-12) & JP 55 111656 A (MATSUSHITA ELECTRIC IND CO LTD), 28. August 1980 (1980-08-28)

## Beschreibung

Die Erfindung betrifft einen Elektromotor, insbesondere Gleichstrommotor, mit einer Antriebseinheit und einer Steuereinheit mit den im Oberbegriff des Anspruchs 1 genannten Merkmalen.

Elektromotoren, insbesondere Gleichstrommotoren, sind in vielfältigen Bauformen und für vielfältige Einsatzzwecke bekannt. Ein mögliches Einsatzgebiet ist beispielsweise eine Klima-, Lüftungs- und/oder Heizungsanlage eines Kraftfahrzeuges. Hierbei werden Gleichstrommotoren als Gebläsemotoren zum Erzeugen einer gerichteten Luftströmung eingesetzt. Um diese Luftströmung variabel gestalten zu können, beispielsweise hinsichtlich einer Zeitdauer und/oder eines Volumendurchsatzes, ist bekannt, den Gebläsemotoren einen als Steuereinheit ausgebildeten Gebläseregler zuzuordnen. Dieser Gebläseregler umfasst die notwendige Regel- oder Steuerelektronik, um entsprechend vorgebbarer Parameter eine Antriebsdrehzahl des Elektromotors (Gebläsemotors) zu beeinflussen. Diese Steuer- und Regelelektroniken umfassen beispielsweise auch Verlustwärme erzeugende Komponenten, wie beispielsweise Leistungstransistoren. Um diese Verlustwärme abzuführen, ist bekannt, entsprechende Kühlelemente vorzusehen oder die Komponenten mit einem Kühlmittelstrom zu beaufschlagen.

Aus der DE 196 06 487 A1 ist beispielsweise bekannt, eine Steuerelektronik derart anzuordnen, dass diese teilweise in einem Gehäuse des Gebläsemotors angeordnet ist und teilweise aus diesem hinausragt, um von einem von einem Gebläserad erzeugbaren Luftstrom beaufschlagt zu werden. Eine weitere Anordnung ist aus der DE 198 12 729 A1 bekannt, wobei eine Steuereinheit und eine Antriebseinheit eines Elektromotors als Einzelmodule ausgebildet sind und über Kontaktstifte miteinander kontaktierbar sind. Bei diesen bekannten Anordnungen ist nachteilig, dass eine thermische Trennung zwischen Antriebseinheit und Steuereinheit gegeben ist, so dass für erforderliche Kühlmaßnahmen ein erhöhter Bauraumbedarf gegeben ist.

Ferner ist nachteilig, dass durch die Steckverbindung zwischen Steuereinheit und Antriebseinheit minimal vier Kontaktstellen pro Leitung erforderlich sind, die einen erhöhten Arbeitsaufwand erfordern. Ferner ist mit der Erhöhung der Anzahl der Kontaktstellen ein erhöhtes Fehlerpotential durch mögliche Unterbrechungen und die Gefahr eines erhöhten Übergangswiderstandes gegeben.

Aus der FR 2 798 988 A1 ist ein weiterer Gebläsemotor bekannt, bei dem eine Steuerelektronik in einem separaten Gehäuse untergebracht ist. Dieses separate Gehäuse ist mit dem Gebläsemotor verbindbar, wobei durch zugeordnete Anschlusskontakte eine elektrische Verbindung zwischen Antriebseinheit und Steuereinheit herstellbar ist.

In der JP 55111656 A wird ein durchgehendes und mit elektronischen Bauteilen bestückbares, flexibles Substrat vorgeschlagen, weiches auf der äußeren Umfangsfläche eines Motors befestigt werden kann.

In der US 4,810,917 wird eine digitale Impulsgeberanordnung vorgeschlagen, deren Baugruppen im Inneren eines zylindrischen Behälters angeordnet werden. Eine der Baugruppen ist ein durchgehendes, mit elektronischen Bauelementen bestücktes, flexibles Substrat. Das Substrat wird aufgewickelt und zusammen mit den übrigen Baugruppen in den zylindrische Behälter eingeführt, wo es mit einem elektrisch isolierenden Vergussmaterial eingegossen wird.

In der GB 2 174 253 A wird ein Elektromotor beschrieben, an dessen Rückwand eine ebene, mit elektronischen Bauteilen versehene, starre Leiterplatte angeordnet ist. Um die thermische Leitfähigkeit zwischen einzelnen elektronischen Bauteilen und dem Motorengehäuse zu verbessern wird vorgeschlagen, kleinere Ausnehmungen in der Leiterplatte vorzusehen und in diese schraubenförmigen Metallfedem, die sowohl die elektronischen Bauteile als auch das Motorengehäuse berühren, einzubringen.

In der EP 1 235 329 A2 wird ein elektrischer Rotationsaktuator beschrieben, bei dem im rückseitigen Bereich eine durchgehende, mit elektronischen Bauteilen bestückte, flach ausgebildete starre Platine vorgesehen ist. Die Platine wird über Dämpfungsstangen, die flexible Dämpfungselemente aufweisen, mit dem Aktuator verbunden.

Im US-Patent US 5,943,214 wird ein Vibrationsmotor für ein Mobiltelefon beschrieben. Das Mobiltelefon weis eine durchgehende, mit elektronischen Bauelementen bestückte, flexible Leiterplatte auf, die zur Kontaktierung mit dem Vibrationsmotor einen stegartigen Vorsprung aufweiset.

In der EP 0 558 181 A1 wird ein weiterer Elektromotor beschrieben, an dessen Rückwand eine durchgehende, mit elektronischen Bauteilen bestückte, flach ausgebildete starre Platine angeordnet ist.

In der WO 00/44208 wird vorgeschlagen, eine flexible, durchgehende Leiterplatte nicht nur als Befestigungsstruktur für elektronische Bauteile zu verwenden, sondem auch zur mechanischen Lagerung von Bauteilen eines elektromechanischen Wandlers zu verwenden.

In der DE 197 23 664 A1 wird eine Steuereinheit für einen Elektromotor beschrieben, die eine Basis in Form einer flachen Schale aus einem elektrisch isolierenden Werkstoff aufweist, in welche eine mit gedruckten Schaltungen und elektronischen Bauteilen versehene flach ausgebildete starre Platine eingesetzt ist. Die schalenförmige Basis mit der darin eingebrachten Platine wird anschließend mit einer aushärtenden, elektrisch isolierenden Masse verfüllt.

Es ist Aufgabe der Erfindung, einen Elektromotor der gattungsgemäßen Art zu schaffen, der sich durch einen reduzierten Bauraumbedarf und ein reduziertes Gewicht auszeichnet, und bei dem eine besonders gute thermische kopplung zwichen den Komponenten und dem den flexiblen Träger aufnehmenden Gehäuseteil möglich ist.

Erfindungsgemäß wird diese Aufgabe durch einen Elektromotor mit den im Anspruch 1 genannten Merkmalen gelöst.

Es wird vorgeschlagen, dass die Steuereinheit einen flexiblen Träger aufweist, dessen Form an eine Kontur wenigstens eines Gehäuseteiles der Antriebseinheit anpassbar ist und in dieser Form an das wenigstens eine Gehäuseteil festlegbar ist, wird vorteilhaft eine große Packungsdichte von Antriebseinheit und Steuereinheit erreicht, so dass eine Minimierung des Bauraumes möglich ist.

Ferner wird hierdurch vorteilhaft erreicht, dass durch die Anpassung der Form des Trägers der Steuereinheit an die Kontur der Antriebseinheit das wenigstens eine Gehäuseteil gleichzeitig als Kühlkörper für Verlustwärme erzeugende Komponenten der Steuereinheit genutzt werden kann. Somit entfällt die zusätzliche Anordnung eines Kühlkörpers. Dies führt wiederum zu Bauraum- und Gewichtsersparnissen.

Als weiterer Vorteil ergibt sich, dass aufgrund des flexiblen Trägers der Steuereinheit diese problemlos an unterschiedlichen Antriebseinheiten angeordnet werden kann. Eventuelle Konturunterschiede werden durch den flexiblen Träger in einfacher Weise ausgeglichen.

Weiterhin ist vorgesehen, dass in den Bereichen der Steuereinheit, in denen Verlustwärme erzeugende Komponenten, insbesondere Leistungstransistoren, angeordnet sind, der flexible Träger einen der Kontur der Komponenten im Wesentlichen entsprechenden Durchbruch aufweist. Hierdurch wird vorteilhaft erreicht, dass eine besonders gute thermische Kopplung zwischen den Komponenten und dem den flexiblen Träger aufnehmenden Gehäuseteil möglich ist. Eine Verlustwärmeabführung wird hiermit optimal unterstützt.

Außerdem ist vorgesehen, dass den Verlustwärme erzeugenden Komponenten Adapterelemente zugeordnet sind, die zwischen den Komponenten und dem wenigstens einen Gehäuseteil der Antriebseinheit anordenbar sind. Hierdurch wird eine besonders großflächige Anbindung der Komponenten an das Gehäuseteil möglich, so dass die Verlustwärmeableitung durch das Adapterelement besonders gut unterstützt wird. Dazu wird vorgeschlagen, das das Adapterelement einerseits eine dem wenigstens einen Gehäuseteil angepasste erste Kontaktfläche und andererseits eine dem der Komponente angepasste zweite Kontaktfläche besitzt, und so eine großflächige Ankopplung der Komponenten an das Gehäuseteil möglich wird, so dass eine Ableitung der Verlustwärme durch den hierdurch erzielbaren großen Temperaturgradienten zwischen Komponente und Gehäuseteil besonders optimal erfolgen kann.

Darüber hinaus ist in bevorzugter Ausgestaltung der Erfindung vorgesehen, dass der flexible Träger einen Anschlussbereich ausbildet, der die Anschlusskontakte der Steuereinheit aufweist, wobei insbesondere der Anschlussbereich des Trägers mit einem Anschlussbereich der Antriebseinheit korrespondiert, so dass die Anschlusskontakte der Steuereinheit und die Anschlusskontakte der Antriebseinheit unmittelbar übereinander liegend angeordnet sind. Hierdurch wird eine direkte elektrische Kontaktierung zwischen den Anschlusskontakten der Steuereinheit und den Anschlusskontakten der Antriebseinheit ohne Zwischenschaltung irgendwelcher elektrischer Verbindungselemente möglich. Die Anzahl der Kontaktstellen wird hierdurch reduziert und die Kontaktsicherheit erhöht.

Darüber hinaus ist in bevorzugter Ausgestaltung der Erfindung vorgesehen, dass der flexible Träger gleichzeitig eine Leiterplatte für die Steuereinheit bildet. Hierdurch können die notwendigen elektrischen Verbindungen zwischen den Komponenten der Steuereinheit und den Anschlusskontakten der Steuereinheit in die Leiterplatte als Leiterbahnen -in an sich bekannter Weise- integriert werden. Zusätzliche Verbindungselemente oder dergleichen entfallen somit.

Ferner ist in bevorzugter Ausgestaltung der Erfindung vorgesehen, dass der flexible Träger mit dem wenigstens einen Gehäuseteil kraftschlüssig verbindbar ist, insbesondere mit dem wenigstens einen Gehäuseteil verklebt ist. Hierdurch wird in besonders einfacher Weise eine dauerhafte Verbindung zwischen Antriebseinheit und Steuereinheit möglich. Aufwendige Montageschritte und zusätzliche Befestigungselemente zur Befestigung der Steuereinheit an der Antriebseinheit entfallen.

Darüber hinaus ist in bevorzugter Ausgestaltung der Erfindung vorgesehen, dass der flexible Träger aus einem recyclebaren Material, insbesondere aus Polyimidimid (PI) besteht. Somit wird vorteilhaft möglich, den Elektromotor nach Beendigung von dessen bestimmungsgemäßen Einsatz, beispielsweise durch Ablauf einer maximalen Gesamtlaufzeit, einer stofflichen Verwertung zuzuführen.

Weitere bevorzugte Ausgestaltungen der Erfindung ergeben sich aus den übrigen, in den Unteransprüchen genannten Merkmalen.

Die Erfindung wird nachfolgend in Ausführungsbeispielen anhand der zugehörigen Zeichnungen näher erläutert. Es zeigen:
- Figur 1: eine schematische Ansicht einer Antriebseinheit eines Elektromotors;
- Figur 2: eine schematische Ansicht einer Steuereinheit in einem ersten Ausführungsbeispiel;
- Figur 3: eine mit der Steuereinheit gemäß Figur 2 komplettierte Antriebseinheit;
- Figur 4: eine schematische Ansicht einer Steuereinheit in einem zweiten Ausführungsbeispiel;
- Figur 5: eine mit der Steuereinheit gemäß Figur 4 komplettierte Antriebseinheit;
- Figur 6: eine schematische Ansicht einer Steuereinheit in einem dritten Ausführungsbeispiel;
- Figur 7: eine mit der Steuereinheit gemäß Figur 6 komplettierte Antriebseinheit und
- Figur 8: eine Detailansicht einer komplettierten Antriebseinheit.

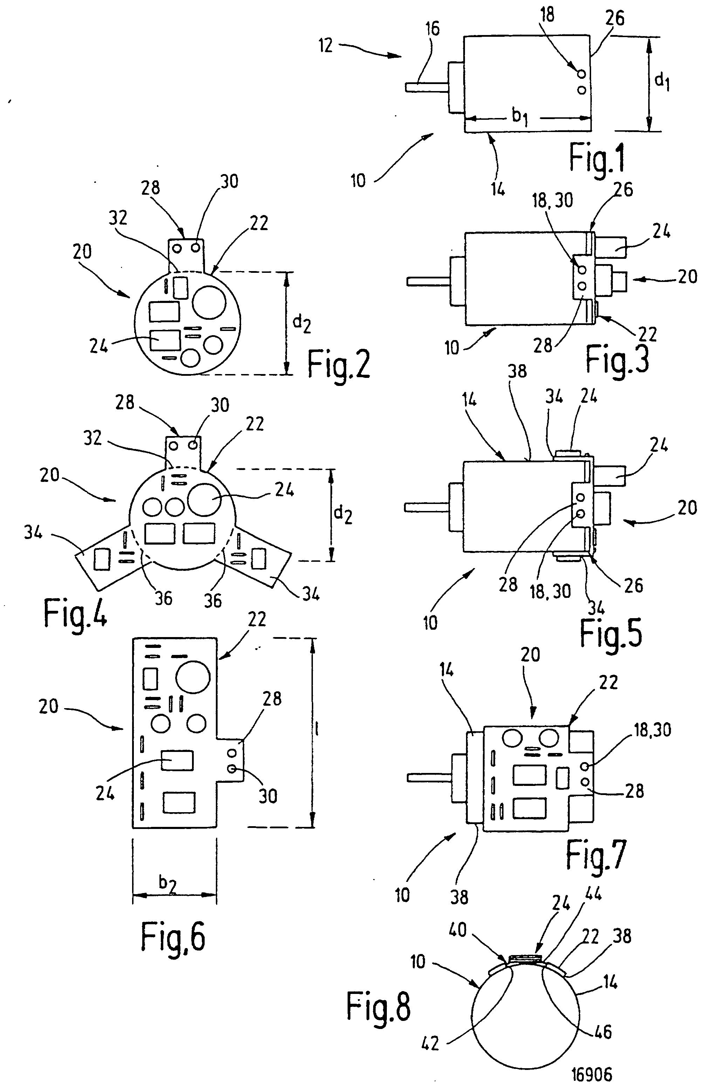

Figur 1 zeigt schematisch eine Antriebseinheit 10 eines Elektromotors, beispielsweise eines Gleichstrommotors 12. Die Antriebseinheit 10 besitzt ein Gehäuse 14, beispielsweise aus Gussmaterial, Aluminium oder anderen geeigneten Materialien, die thermisch leitend sind. Das Gehäuse 14 nimmt einen Rotor und einen Stator des Gleichstrommotors 12 auf. Aus dem Gehäuse 14 ist eine Antriebswelle 16 der Antriebseinheit 10 herausgeführt.

Aufbau und Wirkungsweise derartiger Antriebseinheiten 10 sind allgemein bekannt, so dass im Rahmen der vorliegenden Beschreibung hierauf nicht näher eingegangen werden soll. Derartige, die Antriebseinheit 10 aufweisende Gleichstrommotoren 12 werden beispielsweise als Gebläsemotoren in Heizungs-, Lüftungs- und/oder Klimaanlagen von Kraftfahrzeugen eingesetzt.

Am Gehäuse 14 sind zwei -gegenüber dem Gehäuse 14 elektrisch isoliert- Anschlusskontakte 18 zur Kontaktierung der elektrischen Komponenten der Antriebseinheit 10 angeordnet. Position und Größe der Anschlusskontakte 18 sind in der Regel standardisiert, so dass sich auch bei unterschiedlichen Antriebseinheiten 10, beispielsweise mit unterschiedlichem Durchmesser und unterschiedlichen Leistungsparametern, die Anschlusskontakte 18 immer in definierter Lage befinden.

Figur 2 zeigt schematisch eine Steuereinheit 20. Die Steuereinheit 20 umfasst einen im Wesentlichen flächigen, flexiblen Träger 22, auf dem hier lediglich angedeutete elektronische Komponenten 24, beispielsweise Transistoren, Widerstände, Kondensatoren oder dergleichen angeordnet sind. Der Träger 22 bildet gleichzeitig eine flexible Leiterplatte zur Verdrahtung der Komponenten 24 aus.

Eine Grundfläche des Trägers 22 entspricht im Wesentlichen einer Grundfläche eines Gehäusedeckels 26 (Figur 1) der Antriebseinheit 10. Der Gehäusedeckel 26 ist beispielsweise zylindrisch mit einem Durchmesser d₁ ausgebildet, so dass ein Durchmesser d₂ des Trägers 22 kleiner oder gleich dem Durchmesser d₁ ist.

Der Träger 22 bildet einen Anschlussbereich 28 aus, der Anschlusskontakte 30 der Steuereinheit 20 aufweist. Die Anschlusskontakte 30 sind über in den Träger 22 integrierte -hier nicht dargestellte-Leiterbahnen mit den Komponenten 24 verschaltet.

Figur 3 verdeutlicht die Komplettierung der Steuereinheit 20 mit der Antriebseinheit 10. Hierbei wird der Träger 22 flächig auf den Gehäusedeckel 26 des Gehäuses 14 befestigt, beispielsweise geklebt. Der Gehäusedeckel 26 bildet somit gleichzeitig das Befestigungselement für die Steuereinheit 20 und einen Kühlkörper für Verlustwärme erzeugende Komponenten 24 der Steuereinheit 20 aus. Die elektrische Kontaktierung zwischen Steuereinheit 20 und Antriebseinheit 10 erfolgt über den Anschlussbereich 28 des Trägers 22. Dieser wird entlang einer -in Figur 2 gestrichelt dargestellten- Biegelinie 32 umgeklappt, so dass die Anschlusskontakte 30 der Steuereinheit 20 auf den Anschlusskontakten 18 der Antriebseinheit 10 zu liegen kommen. Die geometrische Lage der Anschlusskontakte 30 ist hierbei der geometrischen Lage der Anschlusskontakte 18 angepasst. Durch elektrisches Verbinden der Anschlusskontakte 18 mit den Anschlusskontakten 30, beispielsweise durch Löten, Foliensteckerstiften oder anderen geeigneten Maßnahmen, erfolgt eine direkte Kontaktierung zwischen Steuereinheit 20 und Antriebseinheit 10.

In den Figuren 4 und 5 ist eine zu den Figuren 2 und 3 abgewandelte Ausführungsform gezeigt. Gleiche Teile sind jeweils mit gleichen Bezugszeichen versehen und nicht nochmals erläutert.

Wie Figur 4 verdeutlicht, besitzt hier der Träger 22 zusätzlich zu seiner im Wesentlichen kreisförmigen Grundform mit dem Durchmesser d₂ Laschen 34, die entlang hier angedeuteter Biegelinien 36 entspringen. Durch die Ausbildung der Laschen 34 steht eine vergrößerte Grundfläche des Trägers 22 zur Verfügung. Diese vergrößerte Grundfläche kann beispielsweise zur Anordnung einer größeren Anzahl von Komponenten 24 genutzt werden.

Wie Figur 5 verdeutlicht, wird der Träger 22 wiederum an dem Gehäusedeckel 26 befestigt, beispielsweise geklebt. Anschließend wird der Anschlussbereich 28 des Trägers 22 umgeklappt, so dass die Kontaktierung der Anschlusskontakte 18 und 30 erfolgen kann. Die Laschen 34 werden ebenfalls entlang der Biegelinien 36 umgeklappt und gelangen somit ebenfalls in Anlagekontakt mit dem Gehäuse 14. Hierdurch erfolgt eine Befestigung der Steuereinheit 20 zusätzlich zum Gehäusedeckel 26 auch an einem Gehäusemantel 38 der Antriebseinheit 10.

Eine weitere Ausführungsvariante ist in den Figuren 6 und 7 verdeutlicht. Hier besitzt der Träger 22 eine im Wesentlichen rechteckige Grundform, wobei eine Breite b₂ kleiner gewählt ist als eine Breite b₁ der Antriebseinheit 10 (Figur 1). Eine Länge 1 des Trägers 22 ist hierbei gleich oder geringer als ein Umfang des Gehäuses 14 der Antriebseinheit 10. Vom Träger 22 entspringt wiederum der Anschlussbereich 28 mit den Anschlusskontakten 30.

Zur Komplettierung -wie Figur 7 zeigt- wird der Träger 22 um das Gehäuse 14 der Antriebseinheit 10 gewickelt, so dass es zu einem großflächigen Anlagekontakt zwischen Steuereinheit 20 und Antriebseinheit 10 kommt. Die Anschlusskontakte 30 liegen wiederum über den Anschlusskontakten 18 und werden elektrisch leitend miteinander verbunden. Als Kontaktfläche für den Träger 22 dient hierbei der Gehäusemantel 38 des Gehäuses 14.

Je nach zur Verfügung stehendem Einbauvolumen und/oder Anzahl und Form der Komponenten 24 der Steuereinheit 20 kann zwischen den verschiedenen Ausführungsvarianten der Steuereinheit 20 gewählt werden. Hierbei erfolgten lediglich beispielhafte Darstellungen, die keinen Anspruch auf Vollständigkeit erheben. So sind weitere -von dem Grundprinzip Gebrauch machende- Ausbildungen der Steuereinheit 20 und deren Befestigung an der Antriebseinheit 10 möglich.

Figur 8 verdeutlicht nochmals ausschnittsweise ein Detail der Anordnung der Steuereinheit 20 auf dem Gehäusemantel 38 des Gehäuses 14. Handelt es sich bei der Komponente 24 der Steuereinheit 20 beispielsweise um eine Verlustwärme erzeugende Komponente, ist eine besonders gute thermische Ankopplung an den Gehäusemantel 38 wünschenswert. Hierzu ist zwischen Komponente 24 und Gehäusemantel 38 ein Adapterelement 40 angeordnet, dessen erste Kontaktfläche 42 dem Gehäusemantel 38 angepasst ist und dessen zweite Kontaktfläche 44 der Komponente 24 angepasst ist. Hierdurch wird eine großflächige Anbindung der Komponente 24 an den Gehäusemantel 38 erreicht. Um einen besonders guten Anpressdruck und somit ein möglichst geringen thermischen Übergangswiderstand zwischen Komponente 24 und Gehäusemantel 38 zu erreichen, kann zusätzlich mindestens ein mechanisches Federelement vorgesehen sein, das den Anpressdruck der Komponente 24 auf das Adapterelement 40 und somit an den Gehäusemantel 38 erhöht.

Der Träger 22 besitzt im Bereich von Verlustwärme erzeugenden Komponenten 24 einen Durchbruch 46. Der Durchbruch 46 gestattet eine selbstjustierte Aufnahme des Adapterelementes 40 und reduziert den thermischen Übergangswiderstand zwischen Komponente 24 und Adapterelement 40. Das Adapterelement 40 besteht aus einem thermisch gut leitfähigen Material, beispielsweise Aluminium.

Anhand der Abbildungen wird ohne weiteres deutlich, dass in einfacher Weise unterschiedliche Steuereinheiten 20 mit unterschiedlichen Antriebseinheiten 10 komplettiert werden können. Hinsichtlich der Auswahl der entsprechenden Steuereinheiten 20 beziehungsweise Antriebseinheiten 10 besteht somit eine hohe Flexibilität. Insbesondere können unterschiedliche Steuereinheiten 20 mit gleichen Antriebseinheiten 10 oder gleiche Steuereinheiten 20 mit unterschiedlichen Antriebseinheiten 10 ohne weiteres kombiniert werden.

## Patentansprüche

1. Elektromotor, insbesondere Gleichstrommotor, mit einer Antriebseinheit und einer Steuereinheit (20), wobei die Antriebseinheit zumindest einen Rotor, einen Stator und ein Gehäuse umfasst und die Steuereinheit eine Schaltungsanordnung zur Steuerung oder Regelung der Antriebseinheit umfasst, wobei Anschlusskontakte der Steuereinheit mit Anschlusskontakten der Antriebseinheit elektrisch leitend miteinander verbunden sind, wobei die Steuereinheit (20) einen flexiblen Träger (22) aufweist, dessen Form an eine zumindest teilweise gekrümmte Kontur wenigstens eines Gehäuseteiles (26, 38) der Antriebseinheit (10) anpassbar ist und in dieser Form an das wenigstens eine Gehäuseteil (26, 38) festlegbar ist, **dadurch gekennzeichnet, dass** in Bereichen der Steuereinheit (20), in denen eine Verlustwärme erzeugende Komponenten (24) der Steuereinheit (20) angeordnet sind, der Träger (22) einen der Kontur der Komponenten (24) im Wesentlichen entsprechenden Durchbruch (46) aufweist, worin ein Adapterelement (40) angeordnet ist, dessen erste Kontaktfläche (42) dem Gehäusemantel (38) angepasst ist und dessen zweite Kontaktfläche (44) der Komponente (24) angepasst ist, wodurch eine großflächige Anbindung der Komponente (24) an den Gehäusemantel (38) erreicht wird.

2. Elektromotor nach Anspruch 1, **dadurch gekennzeichnet, dass** das Adapterelement (40) aus einem Material mit hoher thermischer Leitfähigkeit besteht.

3. Elektromotor nach Anspruch 1 oder 2, **dadurch gekennzeichnet, dass** die Komponente (24) durch ein mechanisches Federelement gegen das Adapterelement(40) und dieses gegen das Gehäuseteil (26, 38) drückbar ist.

4. Elektromotor nach einem der vorhergehenden Ansprüche, **dadurch gekennzeichnet, dass** der Träger (22) einen Anschlussbereich (28) ausbildet, der die Anschlusskontakte (30) der Steuereinheit (20) aufweist.

5. Elektromotor nach Anspruch 4, **dadurch gekennzeichnet, dass** der Anschlussbereich (28) des Trägers (22) mit der Antriebseinheit (10) derart korrespondiert, dass die Anschlusskontakte (30) der Steuereinheit (20) und die Anschlusskontakte (18) der Antriebseinheit (10) unmittelbar übereinander liegend angeordnet sind.

6. Elektromotor nach einem der vorhergehenden Ansprüche, **dadurch gekennzeichnet, dass** der Träger (22) gleichzeitig eine Leiterplatte für die Steuereinheit (20) bildet.

7. Elektromotor nach einem der vorhergehenden Ansprüche, **dadurch gekennzeichnet, dass** der Träger (22) aus einem recyclebaren Material besteht.

8. Elektromotor nach Anspruch 7, **dadurch gekennzeichnet, dass** der Träger (22) aus Polyimid (PI) besteht.

9. Elektromotor nach einem der vorhergehenden Ansprüche, **dadurch gekennzeichnet, dass** der Träger (22) mit dem wenigstens einen Gehäuseteil (26, 38) kraftschlüssig verbindbar ist.

10. Elektromotor nach Anspruch 9, **dadurch gekennzeichnet, dass** der Träger (22) mit dem wenigstens einen Gehäuseteil (26, 38) verklebt ist.

11. Elektromotor nach einem der vorhergehenden Ansprüche, **dadurch gekennzeichnet, dass** der wenigstens eine Gehäuseteil (26) ein Gehäusedeckel ist.

12. Elektromotor nach einem der vorhergehenden Ansprüche, **dadurch gekennzeichnet, dass** der wenigstens eine Gehäuseteil (38) ein Gehäusemantel ist.

13. Elektromotor nach einem der vorhergehenden Ansprüche, **dadurch gekennzeichnet, dass** der Elektromotor (12) ein Gebläsemotor ist.

14. Elektromotor nach einem der vorhergehenden Ansprüche, **dadurch gekennzeichnet, dass** die Steuereinheit (20) einen Gebläseregler umfasst.

## Claims

1. Electric motor, in particular direct-current motor, with a drive unit and a control unit (20), wherein the drive unit comprises at least a rotor, a stator and a housing and the control unit comprises a circuit arrangement for the open or closed loop control of the drive unit, wherein terminal contacts of the control unit are conductively connected to terminal contacts of the drive unit, wherein the control unit (20) features a flexible base (22), the shape of which can be adapted to an at least partially curved contour of at least one housing part (26, 38) of the drive unit (10) and in this way located on the at least one housing part (26, 38), **characterised in that**, in areas of the control unit (20) where waste heat generating components (24) of the control unit (20) are located, the base (22) has an opening (46) essentially corresponding to the contour of the components (24), wherein an adapter element (40) is located, the first contact surface (42) of which matches the housing outer casing (38) while the second contact surface (44) matches the component (24), resulting in a large-area contact between the component (24) and the housing outer casing (38).

2. Electric motor according to claim 1, **characterised in that** the adapter element (40) is made of a material of high thermal conductivity.

3. Electric motor according to claim 1 or 2, **characterised in that** the component (24) is pressed against the adapter element (40) and the latter against the housing part (26, 38) by a mechanical spring element.

4. Electric motor according to any of the preceding claims, **characterised in that** the base (22) forms a connecting area (28) incorporating the terminal contacts (30) of the control unit (20).

5. Electric motor according to claim 4, **characterised in that** the connecting area (28) of the base (22) so corresponds to the drive unit (10) that the terminal contacts (30) of the control unit (20) and the terminal contacts (18) of the drive unit (10) lie immediately on top of one another.

6. Electric motor according to any of the preceding claims, **characterised in that** the base (22) simultaneously forms a circuit board for the control unit (20).

7. Electric motor according to any of the preceding claims, **characterised in that** the base (22) is made of a recyclable material.

8. Electric motor according to claim 7, **characterised in that** the base (22) is made of polyimide (PI).

9. Electric motor according to any of the preceding claims, **characterised in that** the base (22) can be non-positively joined to the at least one housing part (26, 38).

10. Electric motor according to claim 9, **characterised in that** the base (22) is bonded to the at least one housing part (26, 38). ,

11. Electric motor according to any of the preceding claims, **characterised in that** the at least one housing part (26) is a housing cover.

12. Electric motor according to any of the preceding claims, **characterised in that** the at least one housing part (38) is an outer casing.

13. Electric motor according to any of the preceding claims, **characterised in that** the electric motor (12) is a fan motor.

14. Electric motor according to any of the preceding claims, **characterised in that** the control unit (20) incorporates a fan controller.

## Revendications

1. Moteur électrique, en particulier, moteur à courant continu, avec une unité d'entraînement et une unité de commande (20), l'unité de commande comprenant au moins un rotor, un stator et un boîtier et l'unité de commande comprenant un circuit pour commander ou régler l'unité d'entraînement, les contacts de raccordement de l'unité de commande et les contacts de raccordement de l'unité d'entraînement étant reliés entre eux de manière électriquement conductrice, l'unité de commande (20) présentant un support flexible (22) dont la forme est adaptable à un contour courbé du moins partiellement d'au moins une partie de boîtier (26, 38) de l'unité d'entraînement (10) et peut être fixé sous cette forme à la au moins une partie de boîtier (26, 38), **caractérisé en ce que** dans des zones de l'unité de commande (20), dans lesquelles sont disposés des composants (24) de l'unité de commande (20) produisant une perte de chaleur, le support (22) présente un passage (46) correspondant sensiblement aux contours des composants (24), dans lequel un élément d'adaptation (40) est disposé, dont la première surface de contact (42) est adaptée à l'enveloppe de boîtier (44) (38) et la seconde surface de contact est adaptée aux composants (24), moyennant quoi un assemblage des composants (24) sur une grande surface au niveau de l'enveloppe de boîtier (38) est réalisé.

2. Moteur électrique selon la revendication 1, **caractérisé en ce que** l'élément d'adaptation (40) se compose d'une matière ayant une conductivité thermique élevée.

3. Moteur électrique selon la revendication 1 ou 2, **caractérisé en ce que** les composants (24) peuvent être pressés par un élément élastique mécanique contre l'élément d'adaptation (40) et celui-ci contre la partie de boîtier (26, 38).

4. Moteur électrique selon l'une quelconque des revendications précédentes, **caractérisé en ce que** le support (22) forme une zone de raccordement (28), qui présente les contacts de raccordement (30) de l'unité de commande (20).

5. Moteur électrique selon la revendication 4, **caractérisé en ce que** la zone de raccordement (28) du support (22) correspond à l'unité d'entraînement (10) de telle manière que les contacts de raccordement (30) de l'unité de commande (20) et les contacts de raccordement (18) de l'unité d'entraînement (10) soient disposés de façon à se trouver directement les uns sur les autres.

6. Moteur électrique selon l'une quelconque des revendications précédentes, **caractérisé en ce que** le support (22) forme simultanément un circuit imprimé pour l'unité de commande (20).

7. Moteur électrique selon l'une quelconque des revendications précédentes, **caractérisé en ce que** le support (22) se compose d'une matière recyclable.

8. Moteur électrique selon la revendication 7, **caractérisé en ce que** le support (22) se compose de polyimide (PI).

9. Moteur électrique selon l'une quelconque des revendications précédentes **caractérisé en ce que** le support (22) peut être relié par complémentarité de force à la au moins une partie de boîtier (26, 38).

10. Moteur électrique selon la revendication 9, **caractérisé en ce que** le support (22) est collé avec la au moins une partie de boîtier (26, 38).

11. Moteur électrique selon l'une quelconque des revendications précédentes, **caractérisé en ce que** la au moins une partie de boîtier (26) est un couvercle de boîtier.

12. Moteur électrique selon l'une quelconque des revendications précédentes, **caractérisé en ce que** la au moins une partie de boîtier (38) est une enveloppe de boîtier.

13. Moteur électrique selon l'une quelconque des revendications précédentes, **caractérisé en ce que** le moteur électrique (12) est un moteur de ventilateur.

14. Moteur électrique selon l'une quelconque des revendications précédentes, **caractérisé en ce que** l'unité de commande (20) comprend un régulateur de ventilateur.
